# EUROPEAN PATENT APPLICATION

(11) **EP 4 322 218 A1**
(43) Date of publication of application: **14.02.2024**
(21) Application number: 22782812.6
(22) Date of filing: 08.07.2022
(51) Int. Cl.: H01L 27/02, G11C 16/04, G11C 16/06

(54) **SEMICONDUCTOR STRUCTURE AND MEMORY**

(30) Priority: 27.06.2022 CN 202210744736
(71) Applicant: Changxin Memory Technologies, Inc., Hefei, Anhui 230601 (CN)
(72) Inventor: WANG, Xiangyu, Hefei, Anhui 230601 (CN); LI, Ning, Hefei, Anhui 230601 (CN)
(74) Representative: Lavoix
(86) International application number: PCT/CN2022/104699
(87) International publication number: WO 2024/000625

(57) **Abstract**

Embodiments of the disclosure provide a semiconductor structure and a memory. The semiconductor structure includes a first active area; a first gate located on the first active area , the first active area and the first gate being configured to form a first transistor; a second active area , the second active area and the first active area being arranged along a first direction, the second active area and the first active area being independent from each other; a second gate located on the second active area, the second active area and the second gate being configured to form a second transistor, wherein sizes of the first transistor and the second transistor are same, a deviation between an electrical parameter of the first transistor and an electrical parameter of the second transistor is below a preset threshold, and the first transistor and the second transistor belong to a cross coupling amplifying unit.

## Description

### CROSS-REFERENCE TO RELATED APPLICATION

This application is based on and claims priority to Chinese Patent Application No.202210744736.4, filed on June 27, 2022 and entitled "SEMICONDUCTOR STRUCTURE AND MEMORY", which is incorporated herein by reference in its entirety.

### TECHNICAL FIELD

The disclosure relates to a technical field of semiconductors, and in particular to a semiconductor structure and a memory.

### BACKGROUND

In a memory, a sensing amplifier (SA) is an important functional device, which can amplify and output a data signal output from the memory cell, or amplify an external signal and write it into a memory unit. The sensing amplifier consists of a pair of P-type transistors (referred to as PSA) and a pair of N-type transistors (referred to as NSA). However, during the manufacturing process, there are some deviation or mismatch problems in the PSA, which reduces the performance of the sensing amplifier.

### SUMMARY

The disclosure provides a semiconductor structure and a memory, which are capable of improving the symmetry of transistors in a cross coupling structure, reducing the noise caused by a transistor mismatch, and improving the signal amplification performance.

In a first aspect, embodiments of the disclosure provide a semiconductor structure. The semiconductor structure includes a first active area, a first gate, a second active area and a second gate.

The first gate is located on the first active area, and the first active area and the first gate are configured to form a first transistor.

The second active area and the first active area are arranged along a first direction, and the second active area and the first active area are independent from each other.

The second gate is located on the second active area, and the second active area and the second gate are configured to form a second transistor.

Sizes of the first transistor and the second transistor are same, and a deviation between an electrical parameter of the first transistor and an electrical parameter of the second transistor is below a preset threshold, and the first transistor and the second transistor belong to a cross coupling amplifying unit.

In some embodiments, shapes of the first gate and the second gate are same. In the first direction, an upper edge of the first gate is higher than an upper edge of the first active area, and a lower edge of the first gate is lower than a lower edge of the first active area; an upper edge of the second gate is higher than an upper edge of the second active area, and a lower edge of the second gate is lower than a lower edge of the second active area.

In some embodiments, in the first direction, a distance between the upper edge of the first active area and the upper edge of the first gate is a first value; and a distance between the upper edge of the second active area and the upper edge of the second gate is a second value, in which the first value and the second value are same. A distance between the lower edge of the first active area and the lower edge of the first gate is a third value, and a distance between the lower edge of the second active area and the lower edge of the second gate is a fourth value, in which the third value and the fourth value are same.

In some embodiments, the semiconductor structure further includes a first contact region located in the first active area and a second contact region located in the first active area, a third contact region located in the second active area and a fourth contact region located in the second active area. The first contact region, the first gate and the second contact region are arranged along a second direction in sequence. The third contact region, the second gate and the fourth contact region are arranged along the second direction in sequence.

In some embodiments, in the second direction, a distance between the first contact area and the first gate is a fifth value, and a distance between the third contact region and the second gate is a sixth value, and the fifth value and the sixth value are same; a distance between the second contact region and the first gate is a seventh value, and a distance between the fourth contact region and the second gate is an eighth value, and the seventh value and the eighth value are same.

In some embodiments, in the first direction, an upper edge of the second contact region is flush with an upper edge of the first contact region, and a lower edge the second contact region is lower than a lower edge of the first contact region; a lower edge of the fourth contact region is flush with a lower edge of the third contact region, and an upper edge of the fourth contact region is higher than an upper edge of the third contact region.

In some embodiments, in the first direction, an upper edge of the second contact region is higher than an upper edge of the first contact region, and a lower edge the second contact region is lower than a lower edge of the first contact region; an upper edge of the fourth contact region is higher than an upper edge of the third contact region, and a lower edge of the fourth contact region is lower than a lower edge of the third contact region.

In some embodiments, in the first direction, a distance between the upper edge of the first contact region and the upper edge of the second contact region is a ninth value, and a distance between the upper edge of the third contact region and the upper edge of the fourth contact region is a tenth value, in which the ninth value and the tenth value are a same. A distance between the lower edge of the first contact region and the lower edge of the second contact region is an eleventh value, and a distance between the lower edge of the third contact region and the lower edge of the fourth contact region is a twelfth value, in which the eleventh value and the twelfth value are same.

In some embodiments, the ninth value, the tenth value, the eleventh value and the twelfth value are same.

In some embodiments, the semiconductor structure further include: a third gate located on the first active area and disposed at a side of the second contact region away from the first gate, in which the first active area and the third gate are configured to form a third transistor; and a fourth gate located on the second active area and disposed at a side of the fourth contact region away from the second gate, in which the second active area and the fourth gate are configured to form a fourth transistor, in which the third transistor and the fourth transistor belong to another cross coupling amplifying unit.

In some embodiments, the semiconductor structure further includes a five contact regions located in the first active area, and disposed at a side of the third gate away from the second contact region; and a sixth contact region located in the second active area and disposed at a side of the fourth gate away from the fourth contact region.

In some embodiments, shapes of the first contact region and the fifth contact region are same, and shapes of the third contact region and the sixth contact region are same; in the first direction, central points of the first contact region and the fifth contact region are located at a same position, and central points of the third contact region and the sixth contact region are located at a same position. The first gate and the third gate are centrosymmetric with respect to the second contact region; and the second gate and the fourth gate are centrosymmetric with respect to the fifth contact region.

In some embodiments, the first active area, the second active area, the first gate to the fourth gate, the first contact region to the sixth contact region together constitute a repeat unit, and a plurality of the repeat units are arranged along the second direction. A distance between the first gate and the third gate in a same repeat unit is a thirteenth value, and a distance between the first gate in a repeat unit and the third gate in an adjacent repeat unit is a fourteenth value; and a distance between the second gate and the fourth gate in a same repeat unit is a fifteenth value, and a distance between the second gate in a repeat unit and the fourth gate in an adjacent repeat unit is a sixteenth value, in which the thirteenth value, the fourteenth value, the fifteenth value and the sixteenth value are all same.

In some embodiments, the first gate is provided with a seventh contact region, the second gate is provided with an eighth contact region, and the third gate is provided with a ninth contact region, and the fourth gate is provided with a tenth contact region, in which the seventh contact region and the tenth contact region are centrosymmetric, and the eighth contact region and the ninth contact region are centrosymmetric.

In a second aspect, embodiments of the disclosure provide a memory including the semiconductor structure according to the first aspect.

The Embodiments of the disclosure provide a semiconductor structure and a memory. The semiconductor structure includes a first active area; a first gate located on the first active area, in which the first active area and the first gate are configured to form the first transistor; a second active area, in which the second active area and the first active area are arranged along a first direction, and the second active area and the first active area are independent from each other; a second gate located on the second active area, in which the second active area and the second gate are configured to form a second transistor, in which sizes of the first transistor and the second transistor are the same, and a deviation between an electrical parameter of the first transistor and an electrical parameter of the second transistor is below a preset threshold, and the first transistor and the second transistor belong to a cross coupling amplifying unit. In this way, since the first active area and the second active area are independent from each other, the area and shape of the overlapping between the gate and active area of the first transistor are very close to the area and shape of the overlapping between the gate and active area of the second transistor, and thus the symmetry of the first transistor and the second transistor is improved, the deviation between the electrical parameters of first transistor and the second transistor is smaller, the signal amplification capability of the cross coupling amplifying unit can be improved and the performance of the sensing amplifier in the memory is finally improved.

### BRIEF DESCRIPTION OF THE DRAWINGS

FIG. 1 is a schematic structural diagram of a sensing amplifier;
FIG. 2 is a detailed schematic structural diagram of a sensing amplifier;
FIG. 3 is a schematic process structure diagram of a PSA;
FIG. 4 is a schematic structural diagram of a semiconductor structure provided by an embodiment of the disclosure;
FIG. 5 is a schematic diagram of a layout of a semiconductor structure provided by an embodiment of the disclosure;
FIG. 6 is a schematic diagram of another semiconductor structure provided by an embodiment of the disclosure;
FIG. 7 is a schematic diagram of yet another semiconductor structure provided by an embodiment of the disclosure;
FIG. 8 is a schematic diagram of still yet another semiconductor structure provided by an embodiment of the disclosure;
FIG. 9 is a schematic diagram of still yet another semiconductor structure provided by an embodiment of the disclosure;
FIG. 10 is a schematic diagram of still yet another semiconductor structure provided by an embodiment of the disclosure;
FIG. 11 is a schematic performance diagram of a semiconductor structure provided by an embodiment of the disclosure; and
FIG. 12 is a schematic structural diagram of a memory provided by an embodiment of the disclosure.

### DETAILED DESCRIPTION

The technical solutions of embodiments of the disclosure will be clearly and completely described below with reference to the drawings in the embodiments of the disclosure. It can be understood that the specific embodiments described herein are only used to explain the related application, but not to limit the application. In addition, it should also be noted that, for convenience of description, only the parts related to the related application are shown in the drawings.

Unless otherwise defined, all technical and scientific terms used herein have the same meanings as those commonly understood by one person skilled in the art to which this disclosure belongs. The terms used herein are for the purpose of describing specific embodiments only and are not intended to limit the disclosure.

In the following description, reference is made to "some embodiments" that describe subsets of all possible embodiments, but it should be understood that "some embodiments" may be the same subset or different subsets of all possible embodiments and may be combined with each other without conflict.

It should be pointed out that, the term "first/second/third" referred to in the embodiments of the disclosure is used only to distinguish similar objects, and does not represent a specific ordering of objects. It can be understood that the "first/second/third" may be interchanged in a particular order or sequence where permitted to enable the embodiments of the disclosure described herein to be implemented in an order other than that illustrated or described herein.

The abbreviations involved in the disclosure are explained as followed.
MOS: metal-oxide semiconductor field-effect transistor.
PMOS: P-type MOS, which is a semiconductor dominated by the hole conduction, also known as a P-type transistor.
NMOS: N-type MOS, which is a semiconductor dominated by the electronic conduction, also known as an N-type transistor.
BL: bit line.
WL: word line.

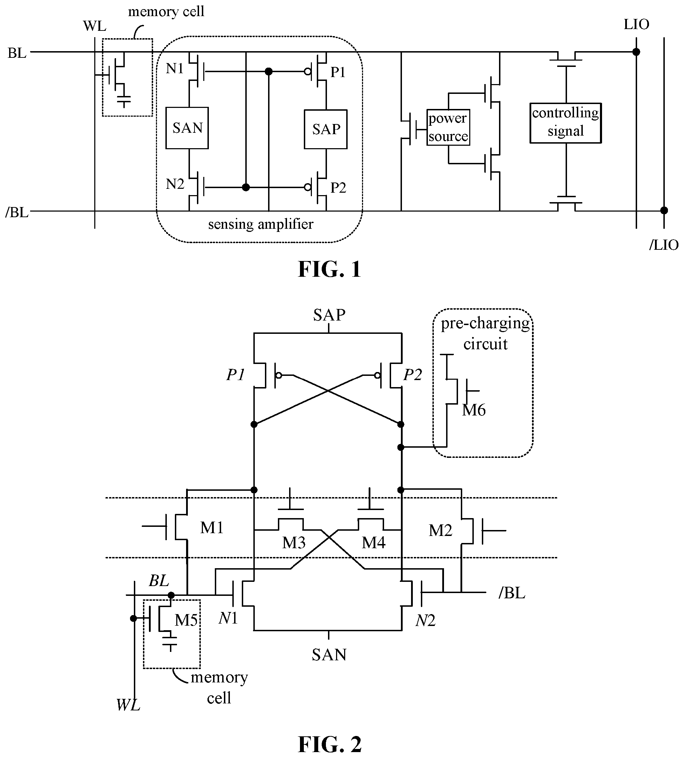

In an integrated circuit, the MOS is still the most commonly used unit device. For a sensing amplifier (SA) in a memory, its core is a cross coupling amplifying unit composed of a pair of NMOSs and a pair of PMOSs. Referring to FIG. 1, which shows a schematic structural diagram of a sensing amplifier. As shown in FIG. 1, the sensing amplifier is disposed between a pair of bit lines (denoted as /BL and BL), and a small signal representing data "0" or data "1" is amplified by a first reference signal SAP and a second reference signal SAN, so as to read the data signal from a memory cell to local data lines (denoted as /LIO and LIO) or write the data signal from the local data lines to the memory cell. Referring to FIG. 2, which shows a detailed schematic structural diagram of a sensing amplifier, as shown in FIG. 1 or FIG. 2, a transistor P1 and a transistor P2 constitute a pair of PMOSs of the cross coupling amplifying unit, also known as PSA, and a transistor N1 and a transistor N2 constitute a pair of NMOSs of the cross coupling amplifying unit, also known as NSA. The amplification effect of the cross coupling amplifying unit depends greatly on the difference between the two paired devices. In addition, other devices in FIG. 1 are used for implementing the pre-charge function or as a transfer switch. In FIG. 2, a transistor M1 and a transistor M2 are used for reducing the noise caused by the NSA mismatch, and a transistor M3 and a transistor M4 are used for isolation, and a transistor M6 is used for the pre-charge processing. The circuit principles of FIG. 1 and FIG. 2 can be inferred with reference to the devices, and this part does not affect the implementation of the embodiments of the disclosure, so it will not be repeated here.

As shown in FIG. 2, the sensing amplifier is disposed with the transistor M1 and the transistor M2 to solve the NSA mismatch problem, but there is no functional device to solve the PSA mismatch problem. Therefore, improving the symmetry of the PSAs to alleviate the mismatch problem is of great significance to the performance of the sensing amplifier.

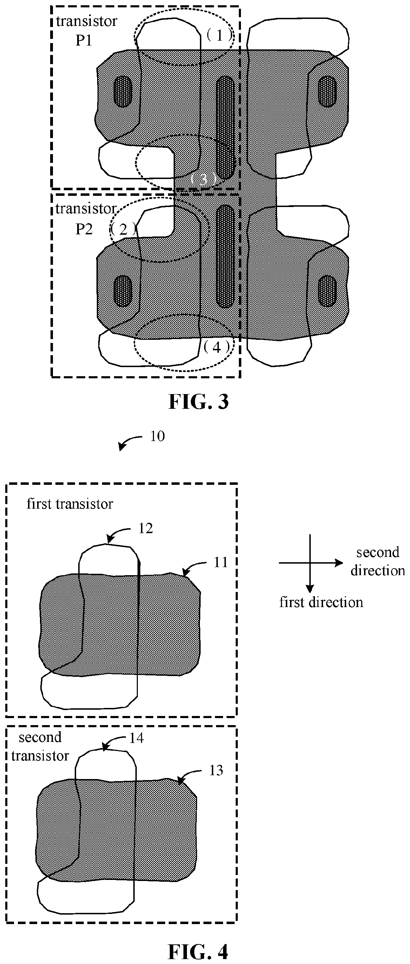

Referring to FIG. 3, which shows a schematic process structure diagram of the PSA. As shown in FIG. 3, in the PSA, the active area of the transistor P1 and the active area of the transistor P2 are connected, at this time, the overlapping region between the gate and active area of the transistor P1 is very different from the overlapping region between the gate and active area of the transistor P2, referring to the position (1) and the position (2) and the position (3) and the position (4) in FIG. 3, which leads to a great difference in electrical properties between the pair of transistors in the PSA. As a result, the amplification performance of the sensing amplifier is reduced, thereby affecting the performance of the memory.

Embodiments of the disclosure provide a semiconductor structure. The semiconductor structure includes a first active area; a first gate located on the first active area, in which the first active area and the first gate are configured to form a first transistor; a second active area, in which the second active area and the first active area are arranged along a first direction, and the second active area and the first active area are independent from each other; a second gate located on the second active area, in which the second active area and the second gate are configured to form a second transistor, in which sizes of the first transistor and the second transistor are the same, and a deviation between an electrical parameter of the first transistor and an electrical parameter of the second transistor is below a preset threshold, and the first transistor and the second transistor belong to a cross coupling amplifying unit. In this way, since the first active area and the second active area are independent from each other, the area and shape of the overlapping between the gate and active area of the first transistor are very close to the area and shape of the overlapping between the gate and active area of second transistor, and thus the symmetry of the first transistor and the second transistor is improved, the deviation between the electrical parameters of first transistor and the second transistor is smaller, the signal amplification capability of the cross coupling amplifying unit can be improved and the performance of a sensing amplifier in a memory is finally improved.

The embodiments of the disclosure are described in detail below with reference to the accompanying drawings.

In an embodiment of the disclosure, referring to FIG. 4, which shows a schematic diagram of a semiconductor structure 10 provided by the embodiments of the disclosure. As shown in FIG. 4, the semiconductor structure 10 may include a first active area 11, a first gate 12, a second active area 13 and a second gate 14.

The first gate 12 is located on the first active area 11, and the first active area 11 and the first gate 12 are configured to form a first transistor.

The second active area 13 and the first active area 11 are arranged along a first direction, and the second active area 13 and the first active area 11 are independent from each other.

The second gate 14 is located on the second active area 13, and the second active area 13 and the second gate 14 are configured to form a second transistor.

Sizes of the first transistor and the second transistor are the same, and a deviation between an electrical parameter of the first transistor and an electrical parameter of the second transistor is below a preset threshold, and the first transistor and the second transistor belong to a cross coupling amplifying unit.

It should be noted that the semiconductor structure 10 provided by the embodiments of the disclosure can be used to form the sensing amplifier. The first transistor and the second transistor are PMOS, that is, the first transistor and the second transistor may be a PSA in the cross coupling amplifying unit.

In addition, the first transistor and the second transistor may also be an NSA in the cross coupling amplifying unit or are applied to other similar circuit structures. The embodiments of the disclosure only take the PSA as an example for subsequent description, but this does not constitute a relevant limitation..

As shown in FIG. 4, since the first active area 11 and the second active area 13 are independent from each other, the area and shape of the overlapping between the gate and active area of the first transistor are very close to the area and shape of the overlapping between the gate and active area of the second transistor, and thus the symmetry of the first transistor and the second transistor is improved, the deviation between the electrical parameters of first transistor and the second transistor is smaller, the signal amplification capability of the cross coupling amplifying unit can be improved and the performance of the sensing amplifier in the memory is finally improved.

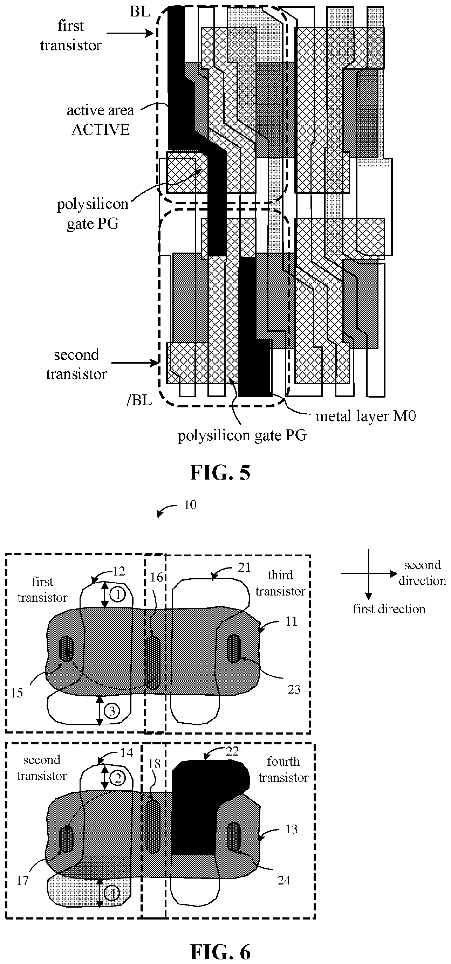

Accordingly, referring to FIG. 5, which shows a schematic diagram of a layout of a semiconductor structure provided by an embodiment of the disclosure, as shown in FIG. 5, the polysilicon gate PG of the first transistor (i.e. the aforementioned first gate 12) and the polysilicon gate PG of the second transistor (i.e. the aforementioned second gate 14) have the same shape, and the electrical connection of contact regions are realized with a metal layer M0 therein. The active area (ACTIVE) of the first transistor (i.e. the aforementioned first active area 11) and the active area (ACTIVE) of the second transistor (i.e. the aforementioned second active area 13) are relatively independent, which can improve the symmetry of the first transistor and the second transistor, and finally improve the performance of the memory.

In some embodiments, as shown in FIG. 4 or FIG. 5, the shape of the first gate 12 is the same as the shape of the second gate 14, and the shape of the first active area 11 is the same as the shape of the second active area 13. On the first direction, an upper edge of the first gate 12 is higher than an upper edge of the first active area 11, and a lower edge of the first gate 12 is lower than a lower edge of the first active area 11, and an upper edge of the second gate 14 is higher than an upper edge of the second active area 13, and a lower edge of the second gate 14 is lower than a lower edge of the second active area 13. In addition, on a second direction, the outer edge of the first active area 11 is located outside the outer edge of the first gate 12, and the outer edge of the second active area 13 is located outside the outer edge of the second gate 14.

In some embodiments, as shown in FIG. 6, in the first direction, a distance between the upper edge of the first active area 11 and the upper edge of the first gate 12 (referring to ① in FIG. 6) is a first value, and a distance between the upper edge of the second active area 13 and the upper edge of the second gate 14 (referring to ② in FIG. 6) is a second value, in which the first value is the same as the second value. A distance between the lower edge of the first active area 11 and the lower edge of the first gate 12 (referring to ③ in FIG. 6) is a third value, and a distance between the lower edge of the second active area 13 and the lower edge of the second gate 14 (referring to ④ in FIG. 6) is a fourth value, in which the third value is the same as the fourth value.

In this way, by controlling the distances between the outer edges of the gates and the outer edges of the active areas, the overlapping regions between the gates and the active areas in the first transistor and the second transistor can be further controlled, which improves the symmetry of the PSA, thereby reducing the noise caused by the PSA mismatch, and finally the performance of the memory can be improved.

In some embodiments, as shown in FIG. 6, the semiconductor structure 10 further includes a first contact region 15, a second contact region 16, a third contact region 17 and a fourth contact region 18.

The first contact region 15 is located in the first active area.

The second contact region 16 is located in the first active area 11, and the first contact region 15, the first gate 12 and the second contact region 16 are arranged along the second direction in sequence.

The third contact region 17 is located in the second active area 13.

The fourth contact region 18 is located in the second active area 13, and the third contact region 17, the second gate 14 and the fourth contact region 18 are arranged along the second direction in sequence.

It should be noted that the contact regions are used to form contact plugs in the later stages to apply voltages to the transistors or lead out currents of the transistors.

In some embodiments, shapes of the first contact region 15 and the third contact region 17 are the same, and shapes of the second contact region 16 and the fourth contact region 18 are the same. Furthermore, in the second direction, a distance between the first contact region 15 and the first gate 12 is a fifth value, and a distance between the third contact region 17 and the second gate 14 is a sixth value, and the fifth value is the same as the sixth value. A distance between the second contact region 16 and the first gate 12 is a seventh value, and a distance between the fourth contact region 18 and the second gate 14 is an eighth value, and the seventh value is the same as the eighth value.

It should also be noted that, as shown in FIG. 6, in the first direction, an upper edge of the first contact region 15 is flush with an upper edge of the second contact region 16. Since the length of the second contact region 16 is greater, a lower edge the second contact region 16 is lower than a lower edge of the first contact region 15. A lower edge of the third contact region 17 is flush with a lower edge of the fourth contact region 18. Since the length of the fourth contact region 18 is greater, an upper edge of the fourth contact region 18 is higher than an upper edge of the third contact region 17. In this structure, the current from source to drain in the transistor are specifically shown as the black dotted lines in FIG. 6, and the two devices are still asymmetric.

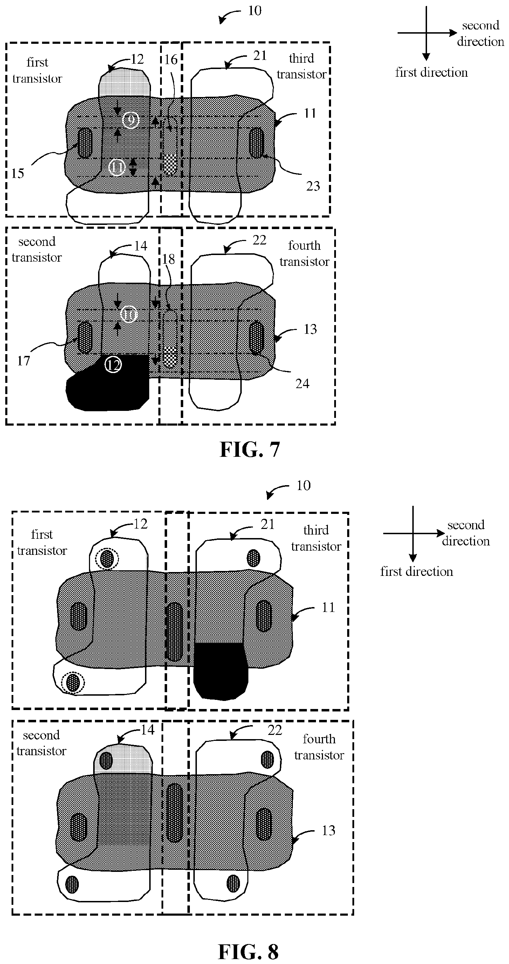

Therefore, in order to further improve the performance of the semiconductor structure 10, the second contact region may be moved up and the fourth contact region may be moved down. Based on such an idea, on the basis of FIG. 6, referring to FIG. 7, an embodiment of the disclosure provide a schematic diagram of yet another semiconductor structure 10. As shown in FIG. 7, for the semiconductor structure 10, in the first direction, the upper edge of the second contact region 16 is higher than the upper edge of the first contact region 15, and the lower edge the second contact region 16 is lower than the lower edge of the first contact region 15, and the upper edge of the fourth contact region 18 is higher than the upper edge of the third contact region 17, and the lower edge of the fourth contact region 18 is lower than the lower edge of the third contact region 17.

It should also be noted that, as shown in FIG. 7, in the first direction, a distance between the upper edge of the first contact region 15 and the upper edge of the second contact region 16 (referring to ⑨ in FIG. 7) is a ninth value, and a distance between the upper edge of the third contact region 17 and the upper edge of the fourth contact region 18 (referring to ⑩ in FIG. 7) is a tenth value, in which the ninth value is the same as the tenth value. A distance between the lower edge of the first contact region 15 and the lower edge of the second contact region 16 (referring to ⑪ in FIG. 7) is a eleventh value, and a distance between the lower edge of the third contact region 17 and the lower edge of the fourth contact region 18 (referring to ⑫ in FIG. 7) is a twelfth value, in which the eleventh value is the same as the twelfth value.

It should be noted that the specific values of the first value to the twelfth value can be determined according to the actual application scenarios when the aforementioned limitations are met. In this way, the relative position of source and drain in the first transistor and second transistor are the same, thereby further alleviating the mismatch between the first transistor and the second transistor, and making the electrical parameters of the first transistor and the second transistor closer. That is to say, under the premise of not changing the original routing mode, the semiconductor structure provided by the embodiments of the disclosure can make the contact regions in the PSA symmetrical, which not only saves unnecessary expenditure, but also effectively alleviates the mismatch of the PSA.

Furthermore, the ninth value, the tenth value, the eleventh value and the twelfth value can be disposed to be the same, so as to better ensure the symmetry of the current channels of the first transistor and the second transistor.

It should be understood that there are a large number of memory cells in the memory that need to be controlled by different bit lines and word lines. Accordingly, there are a plurality of cross coupling amplifying units in the memory, which can amplify signals for the different bit lines.

In some embodiments, as shown in FIG. 6 or FIG. 7, the semiconductor structure 10 further includes a third gate 21 and a fourth gate 22.

The third gate 21 is located on the first active area 11, and the third gate 21 is disposed at a side of the second contact region 16 away from the first gate 12. The first active area 11 and the third gate 21 are configured to form a third transistor.

The fourth gate 22 is located on the second active area 13, and the fourth gate 22 is disposed at a side of the fourth contact region 18 away from the second gate 14. The second active area 13 and the fourth gate 22 are configured to form a fourth transistor.

It should be noted that the third transistor and the fourth transistor belong to another cross coupling amplifying unit, that is, the third transistor and the fourth transistor are a PSA in another cross coupling amplifying unit. Here, the two cross coupling amplifying units can share the active areas, thereby saving process costs.

Similarly, there are contact regions in the third transistor and the fourth transistors. In some embodiments, as shown in FIG. 6 or FIG. 7, the semiconductor structure 10 further includes a fifth contact region 23 and a sixth contact region 24.

The fifth contact region 23 is located in the first active area 11, and the fifth contact region 23 is disposed at a side of the third gate 21 away from the second contact region 16.

The sixth contact region 24 is located in the second active area 13, and the sixth contact region 24 is disposed at a side of the fourth gate 22 away from the fourth contact region 18.

In addition, the third transistor and the first transistor share the second contact region 16, and the fourth transistor and the second transistor share the fourth contact region 18.

It should also be noted that, shapes of the fifth contact region 23 and the first contact region 15 are the same, and shapes of the sixth contact region 24 and the second contact region 16 are the same. In the first direction, central points of the first contact region 15 and the fifth contact region 23 are located at the same position, and central points of the third contact region 17 and the sixth contact region 24 are located at the same position. The first gate 12 and the third gate 21 are centrosymmetric with respect to the second contact region 16, and the second gate 14 and the fourth gate 22 are centrosymmetric with respect to the fifth contact region 18.

In some embodiments, as shown in FIG. 8, the first gate 12 is provided with a seventh contact region, and the second gate 14 is provided with an eighth contact region, and the third gate 21 is provided with a ninth contact region, and the fourth gate 22 is provided with a tenth contact region. The seventh contact region and the tenth contact region are centrosymmetric, and the eighth contact region and the ninth contact region are centrosymmetric, so that the routing of the metal layer M0 is more convenient.

It should be understood that the contact region of each gate actually includes two parts, and the seventh contact region of the first gate 12 includes the two parts circled by the dotted line in FIG. 8.

In some embodiments, the first active area 11, the second active area 13, the first gate 12 to the fourth gate 22, the first contact region 15 to the sixth contact region 24 together constitute a repeat unit, and a plurality of repeat units are arranged along the second direction. A distance between the first gate 12 and the third gate 21 in the same repeat unit is a thirteenth value, and a distance between the first gate 12 in a repeat unit and the third gate 21 in the adjacent repeat unit is a fourteenth value. A distance between the second gate 14 and the fourth gate 22 in the same repeat unit is a fifteenth value, and a distance between the second gate 14 in a repeat unit and the fourth gate 22 in the adjacent repeat unit is a sixteenth value.

In embodiments of the disclosure, the shapes of the first gate 12, the second gate 14, the third gate 21, and the fourth gate 22 can be trimmed by optical proximity processing to ensure that the thirteenth value, the fourteenth value, the fifteenth value, and the sixteenth value are the same.

Exemplarily, the thirteenth value, the fourteenth value, the fifteenth value and the sixteenth value are 60 nanometers.

In a specific example, as shown in FIG. 6 to FIG. 9, the first gate 12 and the second gate 14 are of L shape, and the third gate 21 and the fourth gate 22 are of inverted-L shape. The first gate 12 extends towards the side away from the third gate 21 to form the foot of the L shape; and the third gate 21 extends towards the side away from the first gate 12 to form the foot of the inverted-L shape. The second gate 14 extends towards the side away from the fourth gate 22 to form the foot of the L shape; and the fourth gate 22 extends towards the side away from the second gate 14 to form the foot of the inverted-L shape.

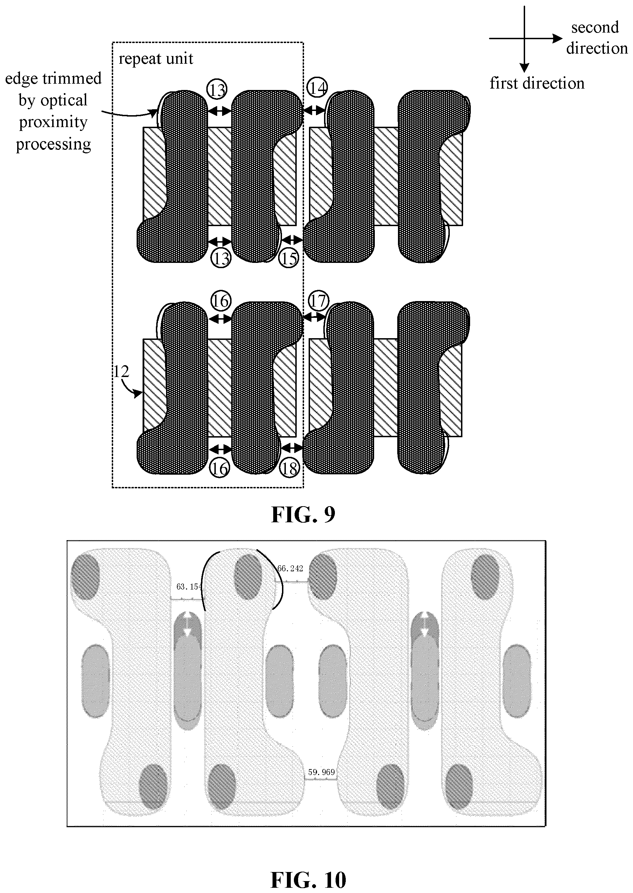

As shown in FIG. 9, the heads of the first gate 12, the second gate 14, the third gate 21, and the fourth gate 22 are trimmed to be larger and more rounded by optical proximity correction processing. The distance between the first gate 12 and the third gate 21 in the same repeat unit (referring to ⑬ in FIG. 9 ), the distance between the head of the first gate 12 and the foot of the third gate 21 in the adjacent repeat unit (referring to ⑭ in FIG. 9), the distance between the foot of the first gate 12 and the head of the third gate 21 in the adjacent repeat unit (referring to 15 in FIG. 9), the distance between the second gate 14 and the fourth gate 22 in the same repeat unit (referring to ⑯ in FIG. 9), the distance between the head of the second gate 14 and the foot of the fourth gate 22 in the adjacent repeat unit being the seventeenth value (referring to ⑰ in FIG. 9), and the distance between the foot of the second gate 14 and the head of the fourth gate 22 in the adjacent repeat unit (referring to ⑱ in FIG. 9) are the same.

In summary, on the basis of separating the active areas of the two PSAs, the symmetry of the two PSAs can be further ensured by adjusting the positions of the contact regions and trimming the shapes of the gates. Referring to FIG. 10, FIG. 10 shows a schematic structural diagram of yet still another semiconductor structure provided by an embodiment of the disclosure. As shown in FIG. 10, by moving the position of the second contact region downward and the position of the fourth contact region (not shown in FIG. 10, which can be understood with the reference to the above description) upward, the symmetry of the contact regions can be improved and the current in the first transistor can be ensured to be the same as the current in the second transistor. In addition, since the distances between different gates are 63.154 nanometers, 66.242 nanometers and 59.969 nanometers respectively, the heads of the gates may be trimmed to be rounder and larger by optical proximity correction (OPC), to ensure that the distances between the different gates are 60 nanometers, further improving the symmetry of PSA, alleviating the mismatch of the PSA and ensuring that the electrical parameters of different cross coupling amplifying units are the same.

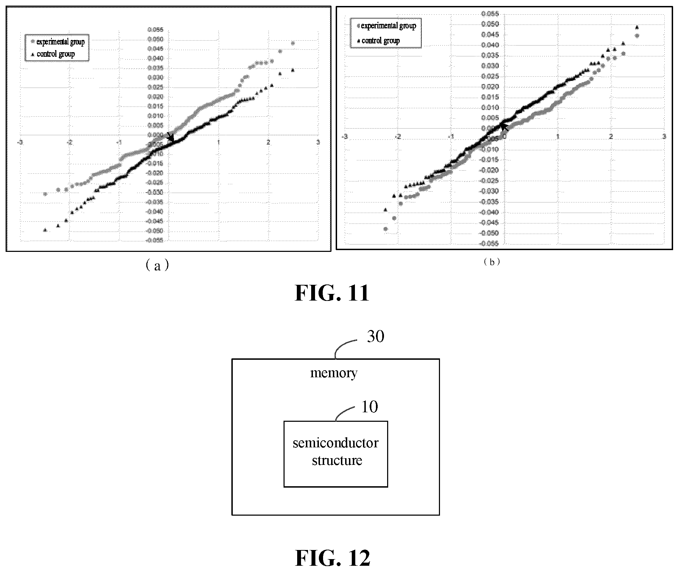

On the basis of FIG. 10, the sensing amplifier is taken as the test object, and referring to FIG. 11, which shows a schematic performance diagram of the semiconductor structure provided by an embodiment of the disclosure. FIG. 11 (A) is used to indicate the mismatch in which a cross coupling amplifying structure is located in the center of a chip, and FIG. 11 (B) is used to indicate the mismatch in which a cross coupling amplifying structure is located at the edge of a chip. In FIG. 11, the control group means that the cross coupling amplifying structure adopts the semiconductor structure shown in FIG. 3, and the experimental group means that the cross coupling amplifying structure adopts the semiconductor structure shown in FIG. 10, and the vertical axis (Y axis) refers to the offset between the first transistor and the second transistor, and the horizontal axis (X axis) refers to statistical coordinates. On the one hand, it can be seen from FIG. 11 that the graph of the experimental group passes through the origin point, so the mismatch of the experimental group is smaller. On the other hand, after the statistics of FIG. 11, it can be got that the variance of the offset of the experimental group is 16.4, and the offset is less than 1; and the variance of the offset in the control group is 16.5, and the offset is about 4, that is, the offset in the experimental group is smaller. That is to say, compared with the control group, the offset of the experimental group is smaller and closer to the origin point, so the gate adjusted by OPC have a better symmetry and uniformity than the traditional gate.

In summary, according to the embodiments of the disclosure, the mismatch problem of the PSA is alleviated by optimizing the structure of the PSA, which improves the amplification performance of the sensing amplifying structure in the memory. First, according to the embodiments of the disclosure, the two active areas in the PSA are separated, so as to control the overlapping regions between the gates (PG) and the active areas (ACTIVE) in different transistors to be in the same state, specifically as shown in FIG. 4 to FIG. 9. On the basis of the above, the positions of the contact regions still adversely affect the symmetry of the two devices in the PSA. Therefore, according to the embodiments of the disclosure, the positions of the contact regions are also adjusted so that the relative positions of the sources and the drains in the transistors are the same, as a result the two devices are more symmetrical, as shown in FIG. 7 and FIG. 9. On the basis of the above, according to the embodiments of the disclosure, the feet of the gates are trimmed to be larger by the OPC, thereby controlling the distances between the gates to be 60 nanometers, further improving the symmetry of the PSA, as shown in FIG. 9 and FIG. 10. That is to say, according to the embodiments of the disclosure, the mismatch of the PSA is alleviated by changing the positions of the active areas and the contact regions in the PSA, which means that the electrical parameters of the two devices in the PSA are more symmetrical.

Embodiments of the disclosure provide a semiconductor structure. The semiconductor structure includes a first active area; a first gate located on the first active area, in which the first active area and the first gate are configured to form the first transistor; the second active area, in which the second active area and the first active area are arranged along the first direction, and the second active area and the first active area are independent from each other; a second gate located on the second active area, in which the second active area and the second gate are configured to form the second transistor, in which sizes of the first transistor and the second transistor are the same, and the deviation between the electrical parameter of the first transistor and the electrical parameter of the second transistor is below the preset threshold, and the first transistor and the second transistor belong to a cross coupling amplifying unit. In this way, since the first active area and the second active area are independent from each other, the area and shape of the overlapping between the gate and active area of the first transistor are very close to the area and shape of the overlapping between the gate and active area of the second transistor, and thus the symmetry of the first transistor and the second transistor is improved, the deviation between the electrical parameters of first transistor and the second transistor is smaller, the signal amplification capability of the cross coupling amplifying unit can be improved and the performance of the sensing amplifier in the memory is finally improved..

In another embodiment of the disclosure, referring to FIG. 12, which shows a schematic structural diagram of a memory 30 provided by the embodiment of the disclosure. As shown in FIG. 12, the memory 30 includes the aforementioned semiconductor structure 10.

For the memory 30, since it includes the semiconductor structure 10, and the first active area and the second active area in the semiconductor structure 10 are independent from each other, the area and shape of the overlapping between the gate and active area of the first transistor are very close to the area and shape of the overlapping between the gate and active area of the second transistor, and thus the symmetry of the first transistor and the second transistor is improved, the deviation between the electrical parameters of first transistor and the second transistor is smaller, the signal amplification capability of the cross coupling amplifying unit can be improved and the performance of the sensing amplifier in the memory is finally improved..

The above are only the preferred embodiments of this disclosure, and are not intended to limit the protection scope of this disclosure. It should be noted that in this disclosure, the term "include", "comprise" or any other variation thereof is intended to cover non-exclusive inclusion, so that a procedure, method, article or device that includes a series of elements not only includes those elements, but also includes other elements not explicitly listed, or also includes elements inherent to such procedure, method, article or device. Without further restrictions, the element defined by the statement "including one ..." does not exclude the existence of another identical element in the procedure, method, article or device that includes the element. The serial numbers of the above disclosed embodiments are for description only, and do not represent the advantages and disadvantages of the embodiments. The methods disclosed in several method embodiments provided in this disclosure may be arbitrarily combined without conflict to obtain a new method embodiment. The features disclosed in several product embodiments provided in this disclosure may be arbitrarily combined without conflict to obtain a new product embodiment. The features disclosed in several method or device embodiments provided by the disclosure may be arbitrarily combined without conflict to obtain a new method embodiment or device embodiment. The above are only some embodiments of the disclosure, but the protection scope of the disclosure is not limited to those. Changes or replacements can be easily thought of by any person skilled in the art and such changes or replacements should be covered by the protection scope of the disclosure. Therefore, the protection scope of the disclosure should be subject to the protection scope of the claims.

### INDUSTRIAL PRACTICABILITY

According to embodiments of the disclosure, since the first active area and the second active area are independent from each other, the area and shape of the overlapping between the gate and active area of the first transistor are very close to the area and shape of the overlapping between the gate and active area of the second transistor, and thus the symmetry of the first transistor and the second transistor is improved, the deviation between the electrical parameters of first transistor and the second transistor is smaller, the signal amplification capability of the cross coupling amplifying unit can be improved and the performance of the sensing amplifier in the memory is finally improved.

## Claims

1. A semiconductor structure, comprising:
a first active area;
a first gate located on the first active area, the first active area and the first gate being configured to form a first transistor;
a second active area, the second active area and the first active area being arranged along a first direction, the second active area and the first active area being independent from each other; and
a second gate located on the second active area, the second active area and the second gate being configured to form a second transistor,
wherein sizes of the first transistor and the second transistor are same, and a deviation between an electrical parameter of the first transistor and an electrical parameter of the second transistor is below a preset threshold, and the first transistor and the second transistor belong to a cross coupling amplifying unit.

2. The semiconductor structure according to claim 1, wherein shapes of the first gate and the second gate are same;
in the first direction, an upper edge of the first gate is higher than an upper edge of the first active area, and a lower edge of the first gate is lower than a lower edge of the first active area; an upper edge of the second gate is higher than an upper edge of the second active area, and a lower edge of the second gate is lower than a lower edge of the second active area.

3. The semiconductor structure according to claim 2, wherein,
in the first direction, a distance between the upper edge of the first active area and the upper edge of the first gate is a first value; and a distance between the upper edge of the second active area and the upper edge of the second gate is a second value, wherein the first value and the second value are same; and
a distance between the lower edge of the first active area and the lower edge of the first gate is a third value, and a distance between the lower edge of the second active area and the lower edge of the second gate is a fourth value, wherein the third value and the fourth value are same.

4. The semiconductor structure according to claim 1, further comprising:
a first contact region located in the first active area;
a second contact region located in the first active area, the first contact region, the first gate and the second contact region being arranged along a second direction in sequence;
a third contact region located in the second active area; and
a fourth contact region located in the second active area, the third contact region, the second gate and the fourth contact region being arranged along the second direction in sequence.

5. The semiconductor structure according to claim 4, wherein,
in the second direction, a distance between the first contact region and the first gate is a fifth value, and a distance between the third contact region and the second gate is a sixth value, and the fifth value and the sixth value are same; a distance between the second contact region and the first gate is a seventh value, and a distance between the fourth contact region and the second gate is an eighth value, and the seventh value and the eighth value are same.

6. The semiconductor structure according to claim 4, wherein,
in the first direction, an upper edge of the second contact region is flush with an upper edge of the first contact region, and a lower edge the second contact region is lower than a lower edge of the first contact region; a lower edge of the fourth contact region is flush with a lower edge of the third contact region, and an upper edge of the fourth contact region is higher than an upper edge of the third contact region.

7. The semiconductor structure according to claim 4, wherein,
in the first direction, an upper edge of the second contact region is higher than an upper edge of the first contact region, and a lower edge of the second contact region is lower than a lower edge of the first contact region; an upper edge of the fourth contact region is higher than an upper edge of the third contact region, and a lower edge of the fourth contact region is lower than a lower edge of the third contact region.

8. The semiconductor structure according to claim 7, wherein,
in the first direction, a distance between the upper edge of the first contact region and the upper edge of the second contact region is a ninth value, and a distance between the upper edge of the third contact region and the upper edge of the fourth contact region is a tenth value, wherein the ninth value and the tenth value are same; and
a distance between the lower edge of the first contact region and the lower edge of the second contact region is an eleventh value, and a distance between the lower edge of the third contact region and the lower edge of the fourth contact region is a twelfth value, wherein the eleventh value and the twelfth value are same.

9. The semiconductor structure according to claim 8, wherein,
the ninth value, the tenth value, the eleventh value and the twelfth value are same.

10. The semiconductor structure according to claim 4, further comprising:
a third gate located on the first active area and disposed at a side of the second contact region away from the first gate, the first active area and the third gate being configured to form a third transistor; and
a fourth gate located on the second active area and disposed at a side of the fourth contact region away from the second gate, the second active area and the fourth gate being configured to form a fourth transistor,
wherein the third transistor and the fourth transistor belong to another cross coupling amplifying unit.

11. The semiconductor structure according to claim 10, further comprising:
a five contact region located in the first active area and disposed at a side of the third gate away from the second contact region; and
a sixth contact region located in the second active area and disposed at a side of the fourth gate away from the fourth contact region.

12. The semiconductor structure according to claim 11, wherein,
shapes of the first contact region and the fifth contact region are same, and shapes of the third contact region and the sixth contact region are same;
in the first direction, central points of the first contact region and the fifth contact region are located at a same position, and central points of the third contact region and the sixth contact region are located at a same position; and
the first gate and the third gate are centrosymmetric with respect to the second contact region; and the second gate and the fourth gate are centrosymmetric with respect to the fifth contact region.

13. The semiconductor structure according to claim 12, wherein the first active area, the second active area, the first gate to the fourth gate, the first contact region to the sixth contact region together constitute a repeat unit, and a plurality of the repeat units are arranged along the second direction;
a distance between the first gate and the third gate in a same repeat unit is a thirteenth value, and a distance between the first gate in a repeat unit and the third gate in an adjacent repeat unit is a fourteenth value; and
a distance between the second gate and the fourth gate in a same repeat unit is a fifteenth value, and a distance between the second gate in a repeat unit and the fourth gate in an adjacent repeat unit is a sixteenth value,
wherein the thirteenth value, the fourteenth value, the fifteenth value and the sixteenth value are same.

14. The semiconductor structure according to claim 12, wherein the first gate is provided with a seventh contact region, the second gate is provided with an eighth contact region, the third gate is provided with a ninth contact region, and the fourth gate is provided with a tenth contact region, wherein
the seventh contact region and the tenth contact region are centrosymmetric, and the eighth contact region and the ninth contact region are centrosymmetric.

15. A memory, comprising the semiconductor structure according to any one of claims 1 to 14.
